(19) Europäisches Patentamt
European Patent Office
Office européen des brevets

(11) **EP 3 411 515 B1**

(12) **EUROPÄISCHE PATENTSCHRIFT**

(45) Veröffentlichungstag und Bekanntmachung des Hinweises auf die Patenterteilung:
**13.01.2021 Patentblatt 2021/02**

(21) Anmeldenummer: **17701854.6**

(22) Anmeldetag: **24.01.2017**

(51) Int Cl.:
*C30B 15/20* [(2006.01)]  *C30B 15/30* [(2006.01)]
*C30B 29/06* [(2006.01)]

(86) Internationale Anmeldenummer:
**PCT/EP2017/051446**

(87) Internationale Veröffentlichungsnummer:
**WO 2017/133930 (10.08.2017 Gazette 2017/32)**

(54) **VERFAHREN ZUM ERMITTELN UND REGELN EINES DURCHMESSERS EINES EINKRISTALLS BEIM ZIEHEN DES EINKRISTALLS**

METHOD FOR DETERMINING AND REGULATING A DIAMETER OF A SINGLE CRYSTAL DURING PULLING OF THE SINGLE CRYSTAL

PROCÉDÉS DE DÉTERMINATION ET DE RÉGULATION D'UN DIAMÈTRE D'UN MONOCRISTAL LORS DU TIRAGE DU MONOCRISTAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.02.2016 DE 102016201778**

(43) Veröffentlichungstag der Anmeldung:
**12.12.2018 Patentblatt 2018/50**

(73) Patentinhaber: **Siltronic AG**
**81737 München (DE)**

(72) Erfinder:
• **SCHRÖCK, Thomas**
**84556 Kastl (DE)**
• **AUBRUNNER, Thomas**
**83342 Tacherting (DE)**

(74) Vertreter: **Staudacher, Wolfgang**
**Siltronic AG**
**Intellectual Property -LP 244**
**Johannes-Hess-Str. 24**
**84489 Burghausen (DE)**

(56) Entgegenhaltungen:
WO-A1-83/02464    JP-A- S6 321 280
JP-A- H09 221 378    JP-A- 2008 184 362
US-A- 4 660 149

**Beschreibung**

Die vorliegende Erfindung betrifft ein Verfahren zum Ermitteln eines Durchmessers eines Einkristalls beim Ziehen des Einkristalls aus einer Schmelze in einem Tiegel. Der ermittelte Durchmesser kann dann als zu regelnde Größe beim Ziehen des Einkristalls verwendet werden.

Stand der Technik

Beim Ziehen von Einkristallen aus Halbleitermaterial nach der sogenannten Czochralski-Methode muss der Durchmesser des Einkristalls überwacht, d.h. bestimmt und gegebenenfalls beeinflusst werden können. Die Änderung des Durchmessers des Einkristalls, die vom radialen Wachstum des Einkristalls an der Kristallisationsgrenze abhängt, kann beispielsweise beeinflusst werden, indem die Hubgeschwindigkeit des Einkristalls und/oder die Temperatur der Schmelze im Bereich der Kristallisationsgrenze gezielt geändert werden.

In der Regel kann der Durchmesser des Einkristalls mittels optischer Erfassungsmittel wie bspw. einer Kamera, ermittelt werden, indem bspw. drei Punkte auf einem den Einkristall im Bereich der Kristallisationsgrenze umgebenden hellen Ring erfasst und daraus der Durchmesser berechnet wird. Bei diesem hellen Ring handelt es sich um eine Reflexion der glühenden Wand des Tiegels, in dem sich die Schmelze befindet, an der flüssigen Schmelze, die im Bereich der Kristallisationsgrenze einen sog. Menikus ausbildet.

Gegen Ende des Ziehvorgangs wird in der Regel ein sog. Endkonus am Einkristall gezogen, d.h. nach einem langen zylindrischen Teil läuft der Einkristall konisch zu einem kleinen Durchmesser zusammen. Auf diese Weise wird vermieden, dass beim Trennen des Einkristalls von der Schmelze entstehende Gleitungen oder Versetzungen im Einkristall weit in den Einkristall, insbesondere in den zylindrischen Teil, welcher anschließend bspw. für die Produktion von Wafern verwendet wird, zurücklaufen.

Da die erwähnte Kamera aufgrund der hohen Temperaturen im Bereich der Schmelze in der Regel außerhalb der zugehörigen Vorrichtung zum Ziehen des Einkristalls angeordnet ist und daher meist nur unter einem relativ steilen Winkel von oben auf die Schmelze sieht, kann der Durchmesser des Einkristalls im Bereich des Endkonus in der Regel nicht mehr erfasst werden.

Es kann bspw. ein sehr langer Endkonus gezogen werden, bei welchem Winkel die Kamera gerade noch den hellen Ring erfassen kann. Dadurch wird jedoch eine sehr große Menge an Material verbraucht, welches anschließend nicht verwendet werden kann und ggf. wieder eingeschmolzen werden muss. Je größer der Durchmesser des Einkristalls im zylindrischen Bereich ist, desto größer ist somit die Menge an Material, die im Endkonus unnötig verbraucht wird.

Es kann auch ein Endkonus gezogen werden, bei dem keine Regelung auf den Durchmesser stattfindet, d.h. das Ziehen des Endkonus wird gesteuert durchgeführt. Damit ist zwar ein kürzerer Endkonus möglich, jedoch kann, wenn ein zu kleiner Winkel erreicht wird, der Einkristall von der Schmelze frühzeitig abreißen. Aufgrund einer fehlenden Regelung kann hier dann nicht mehr korrigierend eingegriffen werden. Dies führt in der Regel zu Gleitungen oder Versetzungen, die in den Einkristall zurücklaufen, wodurch dieser Teil des Einkristalls nicht verwertbar ist.

Aus der EP 0 758 690 A1 ist bspw. ein Verfahren bekannt, bei dem der Durchmesser des Einkristalls im Bereich des Endkonus mittels einer Kamera erfasst wird, wobei ein Spiegel in einem Bereich oberhalb der Oberfläche der Schmelze angeordnet wird. Über den Spiegel kann die Kamera somit den hellen Ring auch bei kleineren Winkeln sehen. Nachteilig ist hierbei jedoch, dass ein solcher Spiegel schwierig anzubringen ist und außerdem sehr leicht beschlägt, da aus der Schmelze Dämpfe aufsteigen.

Aus der JPS 63 021 280 A1 ist ein Verfahren bekannt, bei dem die Position der Kamera während des Ziehens des Endkonus verändert wird, um einen weniger steilen Winkel erfassen zu können. Dies ist jedoch nachteilig, da zum einen ein Mehraufwand beim Verändern der Position der Kamera entsteht und da zum anderen für eine reproduzierbare Einkristallform eine exakt positionierte Kamera erforderlich ist, was bei ständigem Verändern der Position der Kamera nicht mehr sicher gewährleistet werden kann.

Aus der EP 0 498 653 A2 ist ein Verfahren bekannt, bei dem aus einem Gewicht des aus der Schmelze gezogenen Einkristalls ein Absinken der Oberfläche der Schmelze ermittelt wird. Aus dem Absinken kann bspw. eine Höhe, um welche der Tiegel nachgeführt werden muss, ermittelt werden, oder es kann eine optische Durchmesserermittlung des Einkristalls korrigiert werden, indem bspw. der Wert der Höhe der Kamera über der Schmelze korrigiert wird.

Aus der DE 42 31 162 A1 ist ein Verfahren bekannt, um eine Höhe der Oberfläche der Schmelze im Tiegel zu regeln. Hierzu wird ein Abstand der Oberfläche der Schmelze zu einer Referenzmarke ermittelt.

Aus der US 6 106 612 A ist bspw. ein Verfahren bekannt, um eine Position der Oberfläche einer Schmelze in einem Tiegel, aus dem ein Einkristall gezogen wird, relativ zu einem festen Punkt zu ermitteln.

US 4 660 149 A offenbart einen Regelungsprozess für eine Einkristallziehmaschine.

JP 2008 184362 A offenbart eine Methode zum Ziehen eines Einkristalls mit der Czochralski Methode.

JP H09 221378 A offenbart eine Methode zum Ziehen eines Einkristalls mit der Czochralski Methode.

Es ist daher wünschenswert, eine einfache Möglichkeit zur Ermittlung des Durchmessers des Einkristalls beim Ziehen des Einkristalls aus einer Schmelze anzugeben.

Offenbarung der Erfindung

Erfindungsgemäß wird ein Verfahren mit den Merkmalen der unabhängigen Patentansprüche vorgeschlagen. Vorteilhafte Ausgestaltungen sind Gegenstand der Unteransprüche sowie der nachfolgenden Beschreibung.

Vorteile der Erfindung

Ein erfindungsgemäßes Verfahren dient zum Ermitteln eines Durchmessers eines Einkristalls beim Ziehen des Einkristalls, insbesondere eines Endkonus des Einkristalls, aus einer Schmelze in einem Tiegel einer Vorrichtung zum Ziehen des Einkristalls. Bei einer solchen Methode zum Ziehen eines Einkristalls handelt es sich um die sog. Czochralski-Methode. Dabei wird erfindungsgemäß unter Berücksichtigung einer ersten Absinkgeschwindigkeit einer Oberfläche der Schmelze relativ zu dem Tiegel, einer ersten Hubgeschwindigkeit, mit welcher der Einkristall relativ zu dem Tiegel angehoben wird, und einer Massenerhaltung der Durchmesser des Einkristalls an einer Grenzfläche zur Schmelze ermittelt.

Die Erfindung macht sich dabei zunutze, dass die Masse des Materials, in der Regel ein Halbleitermaterial wie Silizium, das am Einkristall kristallisiert und somit vom flüssigen Zustand in der Schmelze in den festen Zustand am Einkristall übergeht, erhalten bleibt. Aus einem Absinken der Oberfläche der Schmelze kann die Masse des Materials, das der Schmelze entnommen und dem Einkristall zugeführt wird, ermittelt werden. Über den erwähnten Zusammenhang der Massenerhaltung entspricht diese Masse der Masse des neu gebildeten, festen Materials am Einkristall. Über die Masse des Materials, das dem Einkristall hinzugefügt wurde, kann nun wiederum auf den Durchmesser des Einkristalls an der Grenzfläche zwischen der Schmelze und dem festen Einkristall, d.h. im Bereich der Kristallisation, geschlossen werden. Für eine zugehörige Formel sei an dieser Stelle auf die Figurenbeschreibung verwiesen.

Besonders vorteilhaft an diesem Verfahren ist nun, dass die Absinkgeschwindigkeit der Oberfläche der Schmelze zur Ermittlung des Durchmessers auf einfache Weise ermittelt werden kann, während der Durchmesser gerade bei einem kurzen Endkonus nicht mehr in herkömmlicher Weise mittels einer Kamera ermittelt werden kann. Eine aufwändige Verstellung der Kamera oder ein Anbringen eines Spiegels ist somit nicht mehr nötig. Hierzu sei noch angemerkt, dass auch die Hubgeschwindigkeit des Einkristalls sehr einfach ermittelt werden kann.

Vorzugsweise werden zur Berücksichtigung der ersten Absinkgeschwindigkeit eine zweite Absinkgeschwindigkeit der Oberfläche der Schmelze relativ zu der Vorrichtung und eine Geschwindigkeit, mit der die Position des Tiegels relativ zu der Vorrichtung geändert wird, ermittelt. Die Geschwindigkeit, mit der die Position des Tiegels geändert wird, ist dabei in der Regel eine ohnehin direkt einstellbare Größe und die zweite Absinkgeschwindigkeit kann sehr einfach durch ein geeignetes Verfahren ermittelt werden, wie es bspw. in der US 6 106 612 A beschrieben wird. Die Differenz der beiden letztgenannten Geschwindigkeiten ergibt dann die erste Absinkgeschwindigkeit. So muss die erste Absinkgeschwindigkeit nicht direkt gemessen werden.

Vorteilhafterweise wird bei der Ermittlung der zweiten Absinkgeschwindigkeit eine Rotation des Tiegels, insbesondere deren Änderung, berücksichtigt. Da im Falle einer Rotation des Tiegels aufgrund der Zentrifugalkraft die Oberfläche der Schmelze im Tiegel zumindest in erster Näherung eine Parabelform aufweist, kann auf diese Weise ein genauerer Wert für die zweite Absinkgeschwindigkeit ermittelt werden. Zweckmäßigerweise wird die zweite Absinkgeschwindigkeit an der radialen Position auf der Oberfläche der Schmelze ermittelt, an der auch der später erwähnte Abstand h bestimmt wird.

Es ist von Vorteil, wenn zur Berücksichtigung der ersten Hubgeschwindigkeit eine zweite Hubgeschwindigkeit, mit welcher der Einkristall relativ zu der Vorrichtung angehoben wird, und eine Geschwindigkeit, mit der die Position des Tiegels relativ zu der Vorrichtung geändert wird, ermittelt werden. Wie bereits erwähnt, ist die Geschwindigkeit, mit der die Position des Tiegels geändert wird, in der Regel eine ohnehin direkt einstellbare Größe. Auch die zweite Hubgeschwindigkeit ist eine in der Regel direkt einstellbare Größe. Auf diese Weise muss die erste Hubgeschwindigkeit nicht direkt gemessen werden.

Vorteilhafterweise wird beim Ermitteln des Durchmessers des Einkristalls ein Dichteunterschied zwischen flüssigem und festem Material der Schmelze bzw. des Einkristalls berücksichtigt. Auf diese Weise kann der aus der Absinkgeschwindigkeit der Oberfläche der Schmelze ermittelte Durchmesser des Einkristalls noch genauer berechnet werden. Hierbei ist zu beachten, dass ein solcher Dichteunterschied bspw. bei Silizium in etwa 10% beträgt.

Es ist von Vorteil, wenn beim Ermitteln des Durchmessers des Einkristalls eine Form des Tiegels berücksichtigt wird. Die Form des Tiegels kann dabei Einfluss auf die der Abnahme der Höhe der Schmelze im Tiegel entsprechenden Masse an Material haben. Im oberen Bereich des Tiegels ist der Tiegel bzw. dessen Wand in der Regel zylindrisch. Nach unten hin zum Boden des Tiegels nimmt der Durchmesser in der Regel jedoch ab. Wird nun bspw. eine Formel, die den Durchmesser des Tiegels beschreibt oder eine entsprechende Tabelle, bspw. eine sog. Look-Up-Tabelle, hinterlegt, so kann sehr einfach über eine aktuelle Position der Oberfläche der Schmelze im Tiegel, welche bspw. aus einer Anfangsposition unter Berücksichtigung des Tiegelhubs und dem Absinken der Oberfläche ermittelt werden kann, der aktuelle Durchmesser des Tiegels an der Position der Oberfläche der Schmelze erhalten werden.

Vorzugsweise wird beim Ermitteln des Durchmessers des Einkristalls während des Ziehens des Endkonus des Einkristalls ein Durchmesser des Tiegels berücksichtigt, welcher Durchmesser des Tiegels aus der ersten oder zweiten Absinkgeschwindigkeit und der ersten oder zweiten Hubgeschwindigkeit unter Berücksichtigung der Massenerhaltung und eines während des Ziehens eines zylindrischen Abschnitts des Einkristalls ermittelten Durchmessers des Einkristalls ermittelt worden ist. Über den oben erwähnten Zusammenhang zwischen Absinkgeschwindigkeit und Hubgeschwindigkeit kann nicht nur der Durchmesser des Einkristalls bei bekanntem Durchmesser des Tiegels ermittelt werden, sondern umgekehrt auch der Durchmesser des Tiegels bei bekanntem Durchmesser des Einkristalls. Auf diese Weise kann also sehr einfach eine eventuelle Abweichung des tatsächlichen Durchmessers des Tiegels von einem Sollwert, was bspw. aufgrund von Fertigungstoleranzen auftreten kann, ermittelt werden. Damit kann nun bspw. die hinterlegte Formel oder Look-Up-Tabelle bzgl. der Form des Tiegels korrigiert werden, wodurch insbesondere im Bereich des Endkonus, wenn die genaue Form des Tiegels möglichst genau bekannt sein sollte, eine genauere Ermittlung des Durchmessers des Einkristalls erfolgen kann.

Erfindungsgemäß wird zusätzlich ein während des Ziehens eines zylindrischen Abschnitts des Einkristalls mittels Beobachtung eines hellen Rings auf der Oberfläche der Schmelze ermittelter Durchmesser des Einkristalls für eine Korrektur oder eine Plausibilitätsprüfung des während des Ziehens des Endkonus des Einkristalls erfindungsgemäß zu ermittelnden Durchmesser(s) des Einkristalls verwendet. Wird der Durchmesser des Einkristalls an einer Position im zylindrischen Teil des Einkristalls auf herkömmliche Weise ermittelt, kann damit unter Berücksichtigung der ersten Absinkgeschwindigkeit, der ersten Hubgeschwindigkeit und der Massenerhaltung auf den Durchmesser des Tiegels an der diesem Durchmesser des Einkristalls entsprechenden Position der Oberfläche der Schmelze geschlossen und festgestellt werden, ob dieser Wert vom hinterlegten oder berechneten Wert des Durchmessers des Tiegels abweicht. Eine gegebenenfalls bestehende Abweichung wird während des Ziehens des Endkonus berücksichtigt, um die Genauigkeit des erfindungsgemäß ermittelten Durchmessers des Einkristalls zu erhöhen. Zweckmäßigerweise wird der Durchmesser des Tiegels während des Ziehens des Endkonus um einen konstanten Offset (relativ oder absolut) korrigiert, der sich aus der festgestellten Abweichung ergibt.

Vorteilhafterweise wird in einem Übergangsbereich zwischen einem zylindrischen Abschnitt des Einkristalls und dem Endkonus und, falls erforderlich, zwischen einem Anfangskonus und dem zylindrischen Abschnitt des Einkristalls, eine Veränderung einer Höhe und/oder einer Form eines Grenzbereiches zwischen der Schmelze und dem festen Einkristall beim Ermitteln des Durchmessers des Einkristalls mittels eines Korrekturfaktors berücksichtigt. Bei diesem Grenzbereich handelt es sich um den sog. Meniskus, der sich zwischen der flüssigen Schmelze und dem festen Einkristall bildet. Sowohl dessen Höhe als auch dessen Form können sich bei einer Änderung der Hubgeschwindigkeit und/oder der Temperatur der Schmelze ändern. Diese Berücksichtigung ist insbesondere dann von Vorteil, wenn eine Änderung der Hubgeschwindigkeit und/oder der Temperatur der Schmelze erfolgen, wie dies im genannten Übergangsbereich der Fall ist. In diesem Übergangsbereich wird gezielt die Hubgeschwindigkeit erhöht, so dass sich die Höhe des Meniskus um bspw. 2 mm erhöht, um ein Wachstum des Einkristalls nach innen zu erreichen. Diese zusätzliche Höhe des Meniskus bewirkt ein Absinken der Oberfläche der Schmelze, jedoch haftet flüssiges Material oberhalb der Position der Oberfläche der Schmelze am Einkristall. Insofern kann hier bspw. der Dichteunterschied zwischen flüssigem und festem Material bei der Durchmesserermittlung als Korrekturfaktor berücksichtigt werden. Alternativ ist es bevorzugt, dass in dem Übergangsbereich, wenn eine vorbestimmte Veränderung einer Höhe und/oder einer Form eines Grenzbereichs zwischen der Schmelze und dem festen Eiskristall auftritt, die Ermittlung des Durchmessers unterbrochen wird. Auf diese Weise werden eventuelle Fehler bei der Durchmesserermittlung vermieden.

Vorzugsweise wird beim Ermitteln des Durchmessers des Einkristalls eine Rauschunterdrückung durchgeführt, insbesondere nach dem Differenzieren von Signalen. Die Rauschunterdrückung erfolgt vorzugsweise mittels eines Filters, beispielsweise Kalman-Filters, eines Beobachters und/oder eines adaptiven Filters.

Zweckmäßigerweise wird der erfindungsgemäß ermittelte Durchmesser des Einkristalls als zu regelnde Größe beim Ziehen des Einkristalls, insbesondere des Endkonus des Einkristalls, verwendet. Wie bereits oben erwähnt, ist eine Regelung auf einen genauen Durchmesser insbesondere im Bereich des Endkonus vorteilhaft, da hiermit ein Endkonus mit kleinem Winkel möglich ist. Auf diese Weise kann Material eingespart und ein frühzeitiges Abreißen des Einkristalls von der Schmelze verhindert werden.

Vorzugsweise werden die erste und/oder die zweite Hubgeschwindigkeit des Einkristalls, eine Geschwindigkeit, mit der die Position des Tiegels geändert wird, ein oder mehrere Leistungen und/oder Temperaturen für die Vorrichtung, und/oder eine Drehgeschwindigkeit des Einkristalls und/oder des Tiegels als Stellgrößen beim Ziehen des Einkristalls verwendet. Bei diesen Größen handelt es sich um die in der Regel beim Ziehen des Einkristalls einzustellenden Größen. Bei der Leistung bzw. der Temperatur kann es sich insbesondere um diejenige eines Heizers, der zum Heizen der Schmelze vorgesehen ist, handeln. Wie bereits erwähnt, spielt die Temperatur der Schmelze eine Rolle beim Wachstum des Einkristalls. Auf diese Weise kann somit eine möglichst genaue Regelung des Durchmessers im Endkonus erfolgen.

Die Erfindung ermöglicht die Erzeugung kürzerer geregelter Endkonen, insbesondere bei Einkristallstäben mit einem Durchmesser von 300 mm und größer. Außerdem wird die Reproduzierbarkeit gegenüber nur gesteuerten Vorgängen erhöht. Es sind keine zusätzlichen Teile wie Spiegel notwendig und eine vorhandene Kamera muss nicht verschoben oder in ihren Parametern geändert werden. Definierte kürzere Endkonen erhöhen die Qualität des erzeugten Einkristallstabes aufgrund vermiedener Gleitungen und verringern den Ausschuss.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

Figurenbeschreibung

Figur 1 zeigt schematisch eine Vorrichtung zum Ziehen eines Einkristalls aus einer Schmelze, bei der ein erfindungsgemäßes Verfahren durchführbar ist.

Figur 2 zeigt einen Ausschnitt aus Figur 1, in welchem ein Grenzbereich zwischen Einkristall und Schmelze detaillierter dargestellt ist.

Figur 3 zeigt einen Ausschnitt aus Figur 1, in welchem ein Teil eines Hitzeschilds über der Oberfläche der Schmelze detaillierter dargestellt ist.

Figur 4 zeigt eine Meniskushöhe bei verschiedenen Phasen des Ziehens eines Einkristalls.

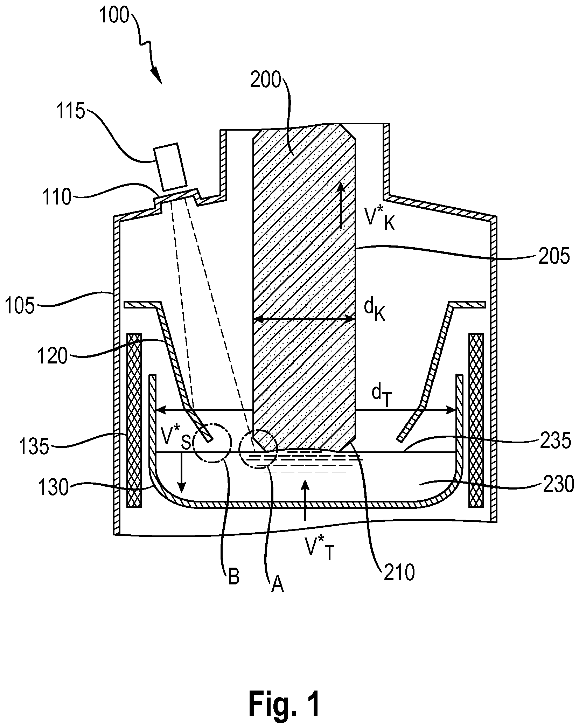

In Figur 1 ist schematisch eine Vorrichtung zum Ziehen eines Einkristalls aus einer Schmelze, bei der ein erfindungsgemäßes Verfahren durchführbar ist, dargestellt. Die Vorrichtung 100 weist ein Gehäuse 105 auf, in welchem ein Tiegel 130 angeordnet ist. Zwischen dem Gehäuse 105 und dem Tiegel 130 ist mindestens eine Heizvorrichtung 135 vorgesehen, mittels welcher der Tiegel 130 aufgeheizt werden kann.

In dem Tiegel 130 ist eine Schmelze 230 aus einem für den Einkristall vorgesehenes Material eingebracht. Bei diesem Material kann es sich bspw. um Silizium handeln. Insbesondere kann dabei polykristallines Silizium in den Tiegel 130 eingebracht werden, welches in dem Tiegel 130 geschmolzen wird und aus welchem anschließend der Einkristall 200 gebildet wird.

Mit $d_T$ ist der Durchmesser des Tiegels 130 bezeichnet. Dabei ist zu erkennen, dass der Tiegel 130 im unteren Bereich, d.h. nahe dem Boden, einen zunehmend geringeren Durchmesser aufweist. Die hier gezeigte Form des Tiegels ist nur beispielhaft und es versteht sich, dass der Tiegel auch andere Formen aufweisen kann. In aller Regel wird jedoch ein Tiegel verwendet, welcher einen nach unten hin abnehmenden Durchmesser aufweist.

Zum Ziehen des Einkristalls 200 wird ein kleiner Einkristall, ein sog. Impfling, in die Schmelze 230 eingebracht und anschließend mittels einer Ziehvorrichtung, die hier nicht gezeigt ist, hochgezogen. Die hier gezeigte Phase des Ziehens des Einkristalls zeigt eine Phase gegen Ende des Ziehens, bei welcher ein sog. Endkonus gezogen wird, d.h. dass der Durchmesser $d_K$ des Einkristalls 200 geringer wird.

Sowohl der Tiegel 130 als auch der Einkristall 200 können dabei bspw. auch rotiert werden. Die Rotationsrichtungen sind dabei in der Regel entgegengesetzt. Diese Rotation ist bspw. dazu vorgesehen, eine im Wesentlichen kreiszylindrische Form des Einkristalls zu erhalten.

Weiterhin ist ein Hitzeschild 120 vorgesehen, wodurch die von der Heizvorrichtung 135 abgegebene Wärme vom oberen Bereich des Einkristalls 200 abgehalten wird.

Weiterhin ist in dem Gehäuse 105 ein Fenster 110 vorgesehen, vor welchem als Kamera ausgebildete optische Erfassungsmittel 115 angebracht sind. Die Kamera 115 weist dabei einen Erfassungsbereich auf, welcher zwischen dem Einkristall 200 und dem Hitzeschild 120 auf die Oberfläche 235 der Schmelze 230 gerichtet ist, wie dies mittels gestrichelter Linien angedeutet ist. Hierbei ist bereits deutlich zu erkennen, dass der Erfassungsbereich der Kamera den Grenzbereich zwischen dem Einkristall 200 und der Oberfläche 235, wie dies im Ausschnitt A zu sehen ist, nicht umfasst. Ein in diesem Grenzbereich gebildeter heller Ring, welcher ansonsten, d.h. bspw. beim Ziehen eines zylindrischen Abschnitts 205 des Einkristalls, von der Kamera erfasst werden kann, kann hier zur Ermittlung des Durchmessers des Einkristalls nicht herangezogen werden.

Weiterhin sind eine zweite Hubgeschwindigkeit $V^*_K$ des Einkristalls 200, mit welcher der Einkristall relativ zur Vorrichtung 100 angehoben wird, eine zweite Absinkgeschwindigkeit $v^*_S$ der Oberfläche 235 der Schmelze 230 relativ zu der Vorrichtung 100 sowie eine Tiegelhubgeschwindigkeit $v^*_T$, mit welcher der Tiegel 230 relativ zur Vorrichtung 100 angehoben wird, schematisch dargestellt.

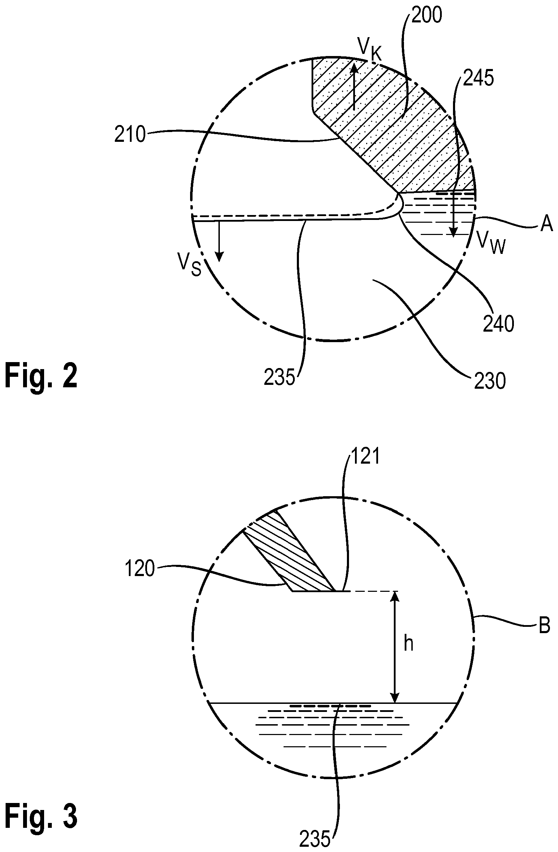

In Figur 2 ist der in Figur 1 eingezeichnete Ausschnitt A detaillierter dargestellt. Insbesondere ist hier der Grenzbereich 240 zwischen der Schmelze 230 und dem Einkristall 200 gezeigt, welcher auch als sog. Meniskus bezeichnet wird. Der feste Einkristall endet dabei an der Grenzfläche 245, unterhalb welcher flüssiges Material vorhanden ist. An der Grenzfläche 245 kristallisiert das flüssige Material mit einer Geschwindigkeit $v_W$.

Weiterhin sind eine erste Hubgeschwindigkeit $v_K$ des Einkristalls 200, mit welcher der Einkristall relativ zum Tiegel 130 angehoben wird, sowie eine erste Absinkgeschwindigkeit $v_S$ der Oberfläche 235 der Schmelze 230 relativ zu dem Tiegel 130 dargestellt. Dabei ergibt sich die Geschwindigkeit $v_W$ aus der ersten Hubgeschwindigkeit $v_K$ und der ersten Absinkgeschwindigkeit $v_S$ als $v_W = v_K + v_S$ unter Berücksichtigung der in der Figur gezeigten Vorzeichen der Geschwindigkeiten.

Die in Figur 2 gezeigten Geschwindigkeiten lassen sich nun in die in Figur 1 gezeigten Geschwindigkeiten umrechnen. Dabei gilt $v_K = v^*_K - v^*_T$ und $v_S = v^*_S - v^*_T$. Dabei ist zu beachten, dass die in Figur 2 gezeigten Geschwindigkeiten auf den Tiegel bezogen sind, weshalb zur Umrechnung die Tiegelhubgeschwindigkeit $v^*_T$ berücksichtigt werden muss.

Die hier mittels einer durchgezogenen Linie gezeichnete Form des Meniskus 240 entspricht einer solchen Form, wie sie in der Regel beim Ziehen des Endkonus vorliegen sollte. Dabei ist zu erkennen, dass die Oberfläche des Meniskus 240 vom Einkristall 200 ausgehend nach innen (in der Figur nach rechts) verläuft. Da der Einkristall in Richtung einer Tangente auf die Oberfläche des Meniskus an der Grenzfläche 245 wächst, kann somit ein Endkonus mit abnehmendem Durchmesser erzeugt werden.

Zusätzlich ist mittels einer gestrichelten Linie neben dem Meniskus 240 noch eine weitere Form eines Meniskus gezeigt, wie sie bspw. beim Ziehen eines Anfangskonus, d.h. mit wachsendem Durchmesser, verwendet wird. Insbesondere ist dabei auch zu sehen, dass die Höhe des Meniskus, d.h. der vertikale Abstand zwischen der Grenzfläche 245 am äußeren Durchmesser des Einkristalls und der Oberfläche 235 von der Form des Meniskus abhängt.

In Figur 3 ist der in Figur 1 eingezeichnete Ausschnitt B detaillierter dargestellt. Insbesondere ist hier ein Teil des Hitzeschilds 120 über der Oberfläche 235 der Schmelze detaillierter dargestellt.

An dem zum Einkristall gewandten und hier rechts gezeigten, unteren Rand des Hitzeschilds 120 ist eine Komponente 121 angebracht. Diese Komponente 121, bspw. in Form einer Aussparung oder einer Zunge, ist somit in der Vorrichtung 100 fixiert. Weiterhin ist ein Abstand h zwischen der Komponente 121 und der Oberfläche 235 gezeigt.

Hierzu sei angemerkt, dass der auf die hier gezeigte Weise definierte Abstand zwischen der Oberfläche 235 und einer in der Vorrichtung 100 fixierten Komponente nur beispielhaft ist. Es kann hierzu auch eine andere, fixierte Komponente verwendet werden, solange sich diese Komponente im Erfassungsbereich der Kamera befindet.

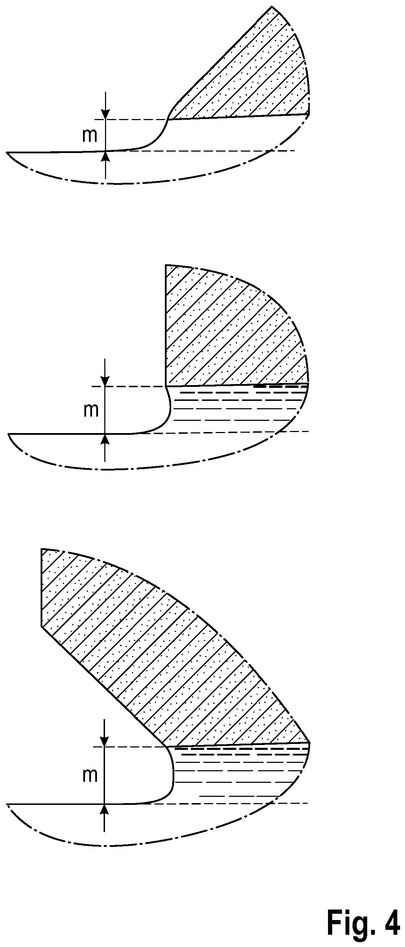

In Figur 4 ist eine Meniskushöhe m bei verschiedenen Phasen des Ziehens des Einkristalls gezeigt. In der oberen Darstellung ist ein Ziehen eines Anfangskonus zu sehen, bei dem eine kleine Meniskushöhe m, bspw. 3 mm, gewählt wird, um eine Zunahme des Durchmessers zu erreichen.

In der mittleren Darstellung ist ein Ziehen eines zylindrischen Abschnitts des Einkristalls gezeigt, bei dem eine mittlere Meniskushöhe, bspw. 7 mm, gewählt wird, um den Durchmesser konstant zu halten. In der unteren Darstellung ist ein Ziehen eines Endkonus gezeigt, bei dem eine große Meniskushöhe, bspw. 9 mm, gewählt wird, um den Durchmesser zu verringern. Dabei ist also zu sehen, dass beim Übergang von dem zylindrischen Abschnitt in den Endkonus die Meniskushöhe m deutlich erhöht wird.

Durch eine zeitliche Ableitung des Abstands h kann nun die zweite Absinkgeschwindigkeit $v^*_S$, mit welcher sich die Position der Oberfläche 235 relativ zur Vorrichtung 100 bewegt, ermittelt werden. Zur Ermittlung des Abstands h sei hier beispielsweise auf die US 6 106 612 A verwiesen. Unter der weiteren Berücksichtigung der ersten Hubgeschwindigkeit $v^*_T$ des Tiegels, welche in der Regel eingestellt wird und daher bekannt ist, kann somit die erste Absinkgeschwindigkeit $v_S$ der Oberfläche 235 der Schmelze relativ zum Tiegel 130 ermittelt werden.

Die zweite Hubgeschwindigkeit $v_K$ des Einkristalls kann unter Berücksichtigung der Tiegelgeschwindigkeit $v^*_T$ aus der zweiten Hubgeschwindigkeit $v^*_K$, mit welcher der Einkristall relativ zur Vorrichtung 100 hochgezogen wird, ermittelt werden.

Es versteht sich, dass beim Ermitteln dieser Geschwindigkeiten, insbesondere der ersten Absinkgeschwindigkeit $v^*_S$ aus der zeitlichen Ableitung des Abstands h, auch verschiedene Operationen wie eine Filterung verwendet werden können, um bessere, rauschärmere Werte zu erhalten. Besonders geeignet sind hierzu bspw. ein Kalman-Filter, ein Beobachter und/oder ein adaptives Filter. Im Vergleich zu einfachen, herkömmlichen Methoden können solche Filter im Sinne numerischer Methoden rauschärmere Ergebnisse erzielen.

Die Formel

$$d_K^2 \cdot \rho_s \cdot (V_K + V_S) = d_T^2 \cdot \rho_f \cdot V_S$$

mit $\rho_s$ und $\rho_f$ den Dichten des festen bzw. des flüssigen Materials des Einkristalls bzw. der Schmelze gibt nun die Massenerhaltung im Bezugsystem des Tiegels an. Dies bedeutet, dass die Masse des Materials, welches sich pro Zeiteinheit als fester Bestandteil des Einkristalls ausbildet, der Masse des dafür verbrauchten flüssigen Materials aus der Schmelze entspricht. Die Geschwindigkeit $v_W$, die hier als $v_K + v_S$ gezeigt ist, gibt dabei die Massenzunahme des Einkristalls an. Aus dieser Beziehung lässt sich nun der Durchmesser $d_K$ des Einkristalls angeben als

$$d_K = d_T \cdot \sqrt{\frac{\rho_f}{\rho_s} \cdot \frac{V_S}{V_K + V_S}}.$$

Die beiden Werte für die Dichte für das feste bzw. flüssige Material sind in aller Regel bekannt und betragen bspw. für Silizium $\rho_s = 2329$ kg/m$^3$ und $\rho_f = 2580$

kg/m$^3$. Die beiden Werte für die Geschwindigkeiten können, wie oben erläutert, ermittelt werden. Werden die Geschwindigkeiten im Bezugssystem des Tiegels ersetzt durch die gemessenen Geschwindigkeiten, so lässt sich der Durchmesser $d_K$ des Einkristalls angeben als

$$d_K = d_T \cdot \sqrt{\frac{\rho_f}{\rho_s} \cdot \frac{(V^*_S + V^*_T)}{(V^*_K + V^*_S)}} \, .$$

Der Durchmesser $d_T$ des Tiegels auf Höhe der Oberfläche kann bspw. anhand der oben erwähnten Form des Tiegels mathematisch oder aus einer Look-Up-Tabelle unter Berücksichtigung der Position der Oberfläche relativ zum Tiegel bzw. dessen Wand ermittelt werden.

Alternativ kann die Form des Tiegels jedoch bspw. auch über eine Formel, bspw. eine analytische, geschlossene Formel oder einen Fit von Polynomen höherer Ordnung, insbesondere auch abschnittsweise, angegeben werden. Bei allen Varianten kann dabei bspw. durch Angabe der Position der Oberfläche der Schmelze relativ zum Tiegel sofort der entsprechende Durchmesser des Tiegels erhalten werden. Die Position der Oberfläche der Schmelze relativ zum Tiegel kann bspw. unter Berücksichtigung der Absinkgeschwindigkeiten und der Tiegelhubgeschwindigkeit ermittelt werden.

Auf die hier gezeigte Weise kann nun also der Durchmesser $d_K$ des Einkristalls insbesondere im Bereich des Endkonus ermittelt werden. Dies ermöglicht somit eine Regelung auf den Durchmesser auf eine an sich bekannte Weise. Bspw. können für die Regelung als Stellgrößen die zweite Hubgeschwindigkeit $v^*_K$ des Einkristalls, die Geschwindigkeit $v^*_T$, mit der die Höhe des Tiegels geändert wird, ein oder mehrere Leistungen und/oder Temperaturen der Vorrichtung 100, und/oder eine Drehgeschwindigkeit des Einkristalls und/oder des Tiegels verwendet werden.

Weiterhin kann bei der Ermittlung des Durchmessers $d_K$ des Einkristalls im Übergangsbereich zwischen dem zylindrischen Abschnitt und dem Endkonus, einem sog. Umbiegen, ein Korrekturfaktor berücksichtigt werden, wie dies oben bereits erwähnt wurde. Der Grund hierfür liegt in der plötzlichen Anhebung der Meniskushöhe, wie dies der Figur 4 zu entnehmen ist. Wenn die Unterschiede der Meniskushöhe vor und nach dem Umbiegen bekannt sind, kann unter Berücksichtigung der unterschiedlichen Dichten von festem und flüssigem Material ein Korrekturfaktor ermittelt werden. Der Korrekturfaktor kann dann solange verwendet werden, bis sich der Ziehvorgang des Einkristalls wieder eingeschwungen hat. Alternativ kann jedoch in diesem Übergangsbereich auch die Durchmesserermittlung unterbrochen werden, damit kein fehlerhafter Durchmesser ermittelt wird.

## Patentansprüche

1. Verfahren zum Ermitteln eines Durchmessers ($d_K$) eines Einkristalls (200) beim Ziehen eines zylindrischen Abschnitts (205) des Einkristalls (200) und eines Endkonus (210) des Einkristalls (200), aus einer Schmelze (230) in einem Tiegel (130) einer Vorrichtung (100) zum Ziehen des Einkristalls (200), wobei unter Berücksichtigung einer ersten Absinkgeschwindigkeit (vs) einer Oberfläche (235) der Schmelze (230) relativ zu dem Tiegel (130), einer ersten Hubgeschwindigkeit ($v_K$), mit welcher der Einkristall (200) relativ zu dem Tiegel (130) angehoben wird, und einer Massenerhaltung der Durchmesser ($d_K$) des Einkristalls (200) an einer Grenzfläche zur Schmelze (230) ermittelt wird, wobei ein während des Ziehens des zylindrischen Abschnitts (205) des Einkristalls (200) mittels Beobachtung eines hellen Rings auf der Oberfläche (235) der Schmelze (230) ermittelter Durchmesser des Einkristalls (200) für eine Korrektur oder eine Plausibilitätsprüfung des während des Ziehens des Endkonus (210) des Einkristalls zu ermittelnden Durchmessers ($d_K$) des Einkristalls (200) verwendet wird.

2. Verfahren nach Anspruch 1, wobei zur Berücksichtigung der ersten Absinkgeschwindigkeit (vs) der Oberfläche (235) der Schmelze (230) relativ zu dem Tiegel (130) eine zweite Absinkgeschwindigkeit ($v^*s$) der Oberfläche (235) der Schmelze (230) relativ zu der Vorrichtung (100) und eine Geschwindigkeit ($v^*_T$), mit der die Position des Tiegels (130) relativ zu der Vorrichtung (100) geändert wird, ermittelt werden.

3. Verfahren nach Anspruch 1 oder 2, wobei bei der Ermittlung der zweiten Absinkgeschwindigkeit ($v^*_S$) eine Rotation des Tiegels (130) und deren Änderung berücksichtigt wird.

4. Verfahren nach einem der vorstehenden Ansprüche, wobei zur Berücksichtigung der ersten Hubgeschwindigkeit ($v_K$), mit welcher der Einkristall (200) relativ zu dem Tiegel (130) angehoben wird, eine zweite Hubgeschwindigkeit ($v^*_K$), mit welcher der Einkristall (200) relativ zu der Vorrichtung (100) angehoben wird, und eine Geschwindigkeit ($v^*_T$), mit der die Position des Tiegels (130) relativ zu der Vorrichtung (100) geändert wird, ermittelt werden.

5. Verfahren nach einem der vorstehenden Ansprüche, wobei beim Ermitteln des Durchmessers ($d_K$) des Einkristalls (200) ein Dichteunterschied zwischen flüssigem und festem Material der Schmelze (230) bzw. des Einkristalls (200) berücksichtigt wird.

6. Verfahren nach einem der vorstehenden Ansprüche, wobei beim Ermitteln des Durchmessers ($d_K$) des Einkristalls (200) der Durchmesser des Tiegels (130) an der Position der Oberläche der Schmelze berücksichtigt wird.

7. Verfahren nach einem der vorstehenden Ansprüche, wobei beim Ermitteln des Durchmessers ($d_K$) des Einkristalls (200) während des Ziehens des Endkonus (210) des Einkristalls (200) ein Durchmesser ($d_T$) des Tiegels (130) berücksichtigt wird, und die Genauigkeit der Ermittlung des Durchmessers ($d_K$) des Einkristalls (200) erhöht wird, indem der Durchmesser ($d_T$) des Tiegels (130) um einen konstanten Offset korrigiert wird.

8. Verfahren nach einem der vorstehenden Ansprüche, wobei in einem Übergangsbereich zwischen einem zylindrischen Abschnitt (205) des Einkristalls (200) und dem Endkonus (210) eine Veränderung einer Höhe und/oder einer Form eines Grenzbereiches (240) zwischen der Schmelze (230) und dem festen Einkristall (200) beim Ermitteln des Durchmessers ($d_K$) des Einkristalls (200) mittels eines Korrekturfaktors berücksichtigt wird.

9. Verfahren nach einem der Ansprüche 1 bis 7, wobei in einem Übergangsbereich zwischen einem zylindrischen Abschnitt (205) des Einkristalls (200) und dem Endkonus (210), wenn eine vorbestimmte Veränderung einer Höhe und/oder einer Form eines Grenzbereiches (240) zwischen der Schmelze (230) und dem festen Einkristall (200) auftritt, die Ermittlung des Durchmessers des Einkristalls unterbrochen wird.

10. Verfahren nach einem der vorstehenden Ansprüche, wobei beim Ermitteln des Durchmessers ($d_K$) des Einkristalls (200) eine Rauschunterdrückung durchgeführt wird, insbesondere mittels eines Filters, eines Beobachters und/oder eines adaptiven Filters.

11. Verfahren nach einem der vorstehenden Ansprüche, wobei der ermittelte Durchmesser ($d_K$) des Einkristalls (200) als zu regelnde Größe beim Ziehen des Einkristalls (200), insbesondere des Endkonus (210) des Einkristalls (200), verwendet wird.

12. Verfahren nach Anspruch 11, wobei die erste ($v_K$) und/oder zweite Hubgeschwindigkeit ($v^*_K$) des Einkristalls (200), eine Geschwindigkeit ($v_T$), mit der die Position des Tiegels (130) geändert wird, ein oder mehrere Leistungen und/oder Temperaturen der Vorrichtung (100), und/oder eine Drehgeschwindigkeit des Einkristalls (200) und/oder des Tiegels (130) als Stellgrößen beim Ziehen des Einkristalls (200) verwendet werden.

**Claims**

1. Method for determining a diameter (dK) of a single crystal (200) while pulling a cylindrical portion (205) of the single crystal (200) and an end cone (210) of the single crystal (200), from a melt (230) in a crucible (130) of a device (100) for pulling the single crystal (200), wherein taking into account a first sinking speed (vS) of a surface (235) of the melt (230) relative to the crucible (130), a first lifting speed (vK) at which the single crystal (200) is lifted relative to the crucible (130), and mass conservation, the diameter (dK) of the single crystal (200) is determined at an interface with the melt (230), wherein a diameter of the single crystal (200) determined during the pulling of the cylindrical portion (205) of the single crystal (200) by observing a bright ring on the surface (235) of the melt (230) is used for a correction or a plausibility check of the diameter (dK) of the single crystal (200) to be determined during the pulling of the end cone (210) of the single crystal.

2. Method according to claim 1, wherein, in order to take into account the first sinking speed (vS) of the surface (235) of the melt (230) relative to the crucible (130), a second sinking speed (v*S) of the surface (235) of the melt (230) relative to the apparatus (100) and a speed (v*T) at which the position of the crucible (130) relative to the apparatus (100) is changed are determined.

3. Method according to claim 1 or 2, wherein a rotation of the crucible (130) and its change is taken into account when determining the second settling velocity (v*S).

4. Method according to one of the above claims, wherein in order to take into account the first lifting speed (vK) with which the single crystal (200) is lifted relative to the crucible (130), a second lifting speed (v*K) with which the single crystal (200) is lifted relative to the apparatus (100) and a speed (v*T) with which the position of the crucible (130) relative to the apparatus (100) is changed are determined.

5. Method according to one of the above claims, whereby a difference in density between liquid and solid material of the melt (230) or the single crystal (200) is taken into account when determining the diameter (dK) of the single crystal (200).

6. Method according to one of the above claims, whereby the diameter (dK) of the single crystal (200) is determined by taking into account the diameter of the crucible (130) at the position of the surface of the melt.

7. Method according to one of the above claims, wherein a diameter (dT) of the crucible (130) is taken into account when determining the diameter (dK) of the single crystal (200) during the pulling of the end cone (210) of the single crystal (200), and the accuracy of the determination of the diameter (dK) of the single crystal (200) is increased by correcting the diameter (dT) of the crucible (130) by a constant offset.

8.  Method according to one of the above claims, wherein, in a transition region between a cylindrical portion (205) of the single crystal (200) and the end cone (210), a change in a height and/or a shape of a boundary region (240) between the melt (230) and the solid single crystal (200) is taken into account when determining the diameter (dK) of the single crystal (200) by means of a correction factor.

9.  Method according to any one of claims 1 to 7, wherein in a transition region between a cylindrical portion (205) of the single crystal (200) and the end cone (210), when a predetermined change of a height and/or a shape of a boundary region (240) between the melt (230) and the solid single crystal (200) occurs, the determination of the diameter of the single crystal is interrupted.

10. Method according to one of the above claims, wherein noise suppression is carried out when determining the diameter (dK) of the single crystal (200), in particular by means of a filter, an observer and/or an adaptive filter.

11. Method according to one of the above claims, wherein the determined diameter (dK) of the single crystal (200) is used as the variable to be controlled when pulling the single crystal (200), in particular the end cone (210) of the single crystal (200).

12. Method according to claim 11, wherein the first (vK) and/or second lifting speed (v*K) of the single crystal (200), a speed (vT) with which the position of the crucible (130) is changed, one or more powers and/or temperatures of the apparatus (100), and/or a rotational speed of the single crystal (200) and/or of the crucible (130) are used as manipulated variables when pulling the single crystal (200).

**Revendications**

1.  Procédé pour déterminer un diamètre (dK) d'un monocristal (200) tout en tirant une partie cylindrique (205) du monocristal (200) et un cône d'extrémité (210) du monocristal (200), à partir d'une masse fondue (230) dans un creuset (130) d'un appareil (100) pour tirer le monocristal (200), où, en tenant compte d'une première vitesse de descente (vS) d'une surface (235) de la masse fondue (230) par rapport au creuset (130), une première vitesse de remontée (vK) à laquelle le monocristal (200) est remonté par rapport au creuset (130), et la conservation de la masse, le diamètre (dK) du monocristal (200) est déterminé à une interface avec le bain de fusion (230), dans lequel un diamètre du monocristal (200) déterminé pendant le tirage de la partie cylindrique (205) du monocristal (200) par l'observation d'un anneau brillant sur la surface (235) du bain de fusion (230) est utilisé pour une correction ou un contrôle de plausibilité du diamètre (dK) du monocristal (200) à déterminer pendant le tirage du cône terminal (210) du monocristal.

2.  Procédé selon la revendication 1, dans lequel, pour tenir compte de la première vitesse de descente (vS) de la surface (235) de la masse fondue (230) par rapport au creuset (130), on détermine une deuxième vitesse de descente (v*S) de la surface (235) de la masse fondue (230) par rapport à l'appareil (100) et une vitesse (v*T) à laquelle la position du creuset (130) par rapport à l'appareil (100) est modifiée.

3.  Procédé selon la revendication 1 ou 2, dans laquelle une rotation du creuset (130) et son changement sont pris en compte lors de la détermination de la deuxième vitesse de décantation (v*S).

4.  Procédé selon l'une des revendications ci-dessus, dans lequel, pour tenir compte de la première vitesse de levage (vK) avec laquelle le monocristal (200) est soulevé par rapport au creuset (130), on détermine une deuxième vitesse de levage (v*K) avec laquelle le monocristal (200) est soulevé par rapport à l'appareil (100) et une vitesse (v*T) avec laquelle la position du creuset (130) par rapport à l'appareil (100) est modifiée.

5.  Procédé selon l'une des revendications ci-dessus, dans laquelle une différence de densité entre la matière liquide et solide de la masse fondue (230) ou du monocristal (200) est prise en compte pour déterminer le diamètre (dK) du monocristal (200).

6.  Procédé selon l'une des revendications ci-dessus, dans laquelle, pour déterminer le diamètre (dK) du monocristal (200), on prend en compte le diamètre du creuset (130) à la position de la surface du bain de fusion.

7.  Procédé selon l'une des revendications ci-dessus, dans laquelle un diamètre (dT) du creuset (130) est pris en compte lors de la détermination du diamètre (dK) du monocristal (200) pendant le tirage du cône d'extrémité (210) du monocristal (200), et la précision de la détermination du diamètre (dK) du monocristal (200) est augmentée en corrigeant le diamètre (dT) du creuset (130) par un décalage constant.

8. Procédé selon l'une quelconque des revendications ci-dessus, dans lequel, dans une zone de transition entre une partie cylindrique (205) du monocristal (200) et le cône d'extrémité (210), une modification de la hauteur et/ou de la forme d'une zone limite (240) entre la masse fondue (230) et le monocristal solide (200) est prise en compte lors de la détermination du diamètre (dK) du monocristal (200) au moyen d'un facteur de correction.

9. Procédé selon l'une quelconque des revendications 1 à 7, dans lequel, dans une zone de transition entre une partie cylindrique (205) du monocristal (200) et le cône d'extrémité (210), lorsqu'une modification prédéterminée d'une hauteur et/ou d'une forme d'une zone limite (240) entre le bain de fusion (230) et le monocristal solide (200) se produit, la détermination du diamètre du monocristal est interrompue.

10. Procédé selon l'une des revendications ci-dessus, dans laquelle la suppression du bruit est effectuée lors de la détermination du diamètre (dK) du monocristal (200), en particulier au moyen d'un filtre, d'un observateur et/ou d'un filtre adaptatif.

11. Procédé selon l'une des revendications ci-dessus, dans laquelle le diamètre déterminé (dK) du monocristal (200) est utilisé comme la variable à contrôler lors du tirage du monocristal (200), en particulier le cône d'extrémité (210) du monocristal (200).

12. Procédé selon la revendication 11, dans lequel la première (vK) et/ou la deuxième vitesse de levage (v*K) du monocristal (200), une vitesse (vT) avec laquelle la position du creuset (130) est modifiée, une ou plusieurs puissances et/ou températures de l'appareil (100), et/ou une vitesse de rotation du monocristal (200) et/ou du creuset (130) sont utilisées comme variables manipulées pendant le tirage du monocristal (200).

**Fig. 1**

200

$V_K$

245

210

A

$V_S$

$V_W$

240

**Fig. 2**

235

230

121

120

B

h

**Fig. 3**

235

Fig. 4

**EP 3 411 515 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0758690 A1
- JP S63021280 A
- EP 0498653 A2
- DE 4231162 A1
- US 6106612 A
- US 4660149 A
- JP 2008184362 A
- JP H09221378 A